# EUROPÄISCHE PATENTSCHRIFT

(11) **EP 2 596 532 B1**
(45) Veröffentlichungstag und Bekanntmachung des Hinweises auf die Patenterteilung: **05.10.2016**
(21) Anmeldenummer: 11726077.8
(22) Anmeldetag: 25.05.2011
(51) Int. Cl.: H01L 25/16, H01L 33/62, H01L 33/22, H01L 33/38

(54) **OPTOELEKTRONISCHES BAUELEMENT**
OPTOELECTRONIC COMPONENT
COMPOSANT OPTOÉLECTRONIQUE

(30) Priorität: 20.07.2010 DE 102010027679
(43) Veröffentlichungstag der Anmeldung: 29.05.2013
(73) Patentinhaber: OSRAM Opto Semiconductors GmbH, 93055 Regensburg (DE)
(72) Erfinder: HÖPPEL, Lutz, 93087 Alteglofsheim (DE)
(74) Vertreter: Epping - Hermann - Fischer
(86) Internationale Anmeldenummer: PCT/EP2011/058573
(87) Internationale Veröffentlichungsnummer: WO 2012/010352

(56) Entgegenhaltungen:
- EP-A2- 2 194 588
- WO-A1-95/22842
- WO-A1-2006/054616
- WO-A1-2011/003907
- US-A1- 2006 056 123

## Beschreibung

### Optoelektronisches Bauelement

Die Anmeldung betrifft ein optoelektronisches Bauelement, das einen Halbleiterkörper und ein mittels einer Lotschicht mit dem Halbleiterkörper verbundenes Trägersubstrat aufweist.

Die Druckschrift EP 2 194 588 A2 offenbart ein lichtemittierendes Bauelement, bei dem eine Schutzdiode in das Substrat integriert ist. Die Druckschrift WO 95/22842 beschreibt einen integrierten Schaltkreis mit einer Schutzdiode.

Eine Aufgabe der Erfindung besteht darin, ein verbessertes optoelektronisches Bauelement anzugeben, bei dem der Halbleiterkörper mittels einer Lotschicht mit einem Trägersubstrat verbunden ist, wobei sich das optoelektronische Bauelement durch eine geringe Empfindlichkeit gegenüber Kurzschlüssen und/oder elektrostatischen Entladungen (ESD - Electrostatic Discharge) auszeichnet und vergleichsweise einfach herstellbar ist. Diese Aufgabe wird durch ein optoelektronisches Bauelement gemäß dem unabhängigen Anspruch 1 gelöst. Vorteilhafte Ausgestaltungen und Weiterbildungen der Erfindung sind Gegenstand der abhängigen Ansprüche.

Das optoelektronische Bauelement weist gemäß einer Ausführungsform einen Halbleiterkörper auf, der eine Epitaxieschichtenfolge mit einer zur Strahlungserzeugung geeigneten aktiven Schicht aufweist. Weiterhin weist das optoelektronische Bauelement ein Trägersubstrat auf, das mittels einer Lotschicht mit dem Halbleiterkörper verbunden ist. Das Trägersubstrat des optoelektronischen Bauelements ist vorteilhaft aus einem Halbleitermaterial gebildet.

Das Trägersubstrat weist vorteilhaft eine erste Durchkontaktierung und eine zweite Durchkontaktierung auf, die jeweils von einer dem Halbleiterkörper zugewandten ersten Hauptfläche des Trägersubstrats zu einer vom Halbleiterkörper abgewandten zweiten Hauptfläche des Trägersubstrats geführt sind.

Dadurch, dass die Durchkontaktierungen von der ersten Hauptfläche des Trägersubstrats, die über die Lotschicht mit dem Halbleiterkörper verbunden ist, zur gegenüber liegenden zweiten Hauptfläche des Trägersubstrats geführt sind, kann das optoelektronische Bauelement vorteilhaft an der zweiten Hauptfläche des Trägersubstrats mit elektrischen Anschlüssen versehen werden. Insbesondere kann das optoelektronische Bauelement an der zweiten Hauptfläche des Trägersubstrats mit Leiterbahnen einer Leiterplatte verbunden werden, indem beispielsweise die erste Durchkontaktierung mit einer Lotschicht mit einer ersten Leiterbahn einer Leiterplatte und die zweite Durchkontaktierung mit einer zweiten Lotschicht mit einer zweiten Leiterbahn der Leiterplatte verbunden wird. Das optoelektronische Bauelement ist also vorteilhaft oberflächenmontierbar.

Die Epitaxieschichtenfolge weist vorteilhaft einen p-dotierten Halbleiterbereich und eine n-dotierten Halbleiterbereich auf, wobei die erste Durchkontaktierung über einen ersten Teilbereich der Lotschicht mit dem p-dotierten Halbleiterbereich und die zweite Durchkontaktierung über einen zweiten Teilbereich der Lotschicht mit dem n-dotierten Halbleiterbereich elektrisch leitend verbunden sind.

Das Trägersubstrat weist vorteilhaft eine Oberflächendotierzone auf, die sich entlang der ersten Hauptfläche erstreckt. Die Oberflächendotierzone ist also an der dem Halbleiterkörper zugewandten Oberfläche des Trägersubstrats angeordnet.

Die Oberflächendotierzone weist vorteilhaft einen p-leitenden Bereich auf, der einen p-Dotierstoff enthält. Weiterhin weist die Oberflächendotierzone einen an den p-leitenden Bereich angrenzenden n-leitenden Bereich auf, so dass zwischen dem p-leitenden Bereich und dem n-leitenden Bereich ein pn-Übergang ausgebildet ist. Der n-leitende Bereich enthält sowohl einen n-Dotierstoff als auch einen p-Dotierstoff. Der n-leitende Bereich weist den n-Dotierstoff vorteilhaft in einer höheren Konzentration als den p-Dotierstoff auf, so dass er insgesamt n-leitend ist.

Der n-leitende Bereich ist, in einer Aufsicht auf die erste Hauptfläche des Trägersubstrats gesehen, ringförmig um den ersten Durchbruch herum angeordnet. Der n-leitende Bereich ist in diesem Fall also zylinderförmig ausgebildet, wobei die Höhe des Zylinders der Tiefe der Oberflächendotierzone, bevorzugt 0,5 µm bis 4,0 µm, entspricht, und die Wandstärke des Zylinders der Breite des n-leitenden Bereichs, vorzugsweise zwischen 5 µm und 20 µm, entspricht.

Der n-leitende Bereich ist an den ersten Teilbereich der Lotschicht elektrisch angeschlossen, und der p-leitende Bereich ist an den zweiten Teilbereich der Lotschicht elektrisch angeschlossen. Da der erste Teilbereich der Lotschicht mit dem p-dotierten Halbleiterbereich und der zweite Teilbereich der Lotschicht mit dem n-dotierten Halbleiterbereich elektrisch leitend verbunden sind, bildet der pn-Übergang in der Oberflächendotierzone eine Schutzdiode für den Halbleiterkörper aus. Der pn-Übergang in der Oberflächendotierzone ist also antiparallel zu einem pn-Übergang des Halbleiterkörpers geschaltet.

Die in der Oberflächendotierzone ausgebildete Schutzdiode schützt den Halbleiterkörper vor elektrostatischen Entladungen. Durch elektrostatische Entladungen ausgelöste Spannungspulse in Sperrrichtung des Halbleiterkörpers werden durch einen Stromfluss durch den pn-Übergang in der Oberflächendotierzone des Trägersubstrats abgeleitet.

Die Oberflächendotierzone zeichnet sich insbesondere dadurch aus, dass sie vergleichsweise einfach herstellbar ist. Die Oberflächendotierzone ist insbesondere dadurch herstellbar, dass in einem ersten Schritt ein p-Dotierstoff an der ersten Hauptfläche des Trägersubstrats ganzflächig in die Oberfläche diffundiert oder implantiert wird. Im fertigen optoelektronischen Bauelement erstreckt sich die Oberflächendotierzone daher mit Ausnahme der Durchkontaktierungen vorzugsweise entlang der gesamten Hauptfläche des Trägersubstrats.

Der n-leitende Bereich kann in der Oberflächendotierzone dadurch erzeugt werden, dass mittels einer Maske ein n-Dotierstoff in einen Teilbereich des zuvor hergestellten p-leitenden Bereichs implantiert oder diffundiert wird. Das Implantieren oder das Diffundieren des n-Dotierstoffs erfolgt dabei derart, dass die Konzentration des n-Dotierstoffs größer als die des p-Dotierstoffs ist, so dass das Halbleitermaterial in diesem Bereich insgesamt n-leitend ist. Der n-leitende Bereich weist vorzugsweise eine Breite von 5 µm bis 20 µm auf. Unter der Breite wird dabei die Ausdehnung in der Richtung parallel zur ersten Hauptfläche des Trägersubstrats verstanden.

Bei dem Trägersubstrat des optoelektronischen Bauelements handelt es sich vorzugsweise um ein Siliziumsubstrat oder ein Germaniumsubstrat. Ein Trägersubstrat aus einem Halbleitermaterial hat gegenüber einem Trägersubstrat aus beispielsweise einer Keramik den Vorteil, dass es vergleichsweise einfach und kostengünstig mit standardisierten Halbleiterprozessen bearbeitet werden kann. Insbesondere kann durch die Ausbildung der Oberflächendotierzone die Schutzdiode für den Halbleiterkörper mit geringem Herstellungsaufwand erzeugt werden.

Die Dicke des Trägersubstrats beträgt vorzugsweise zwischen einschließlich 100 µm und einschließlich 150 µm.

Die Oberflächendotierzone weist vorzugsweise eine Tiefe von 0,5 µm bis 4 µm auf. Die Oberflächendotierzone erstreckt sich also von der ersten Hauptfläche des Trägersubstrats 0,5 µm bis 4 µm in das Trägersubstrat hinein. Die Tiefe der Oberflächendotierzone ist also vorteilhaft wesentlich geringer als die Dicke des Trägersubstrats.

Die Oberflächendotierzone weist vorzugsweise eine Konzentration an freien Ladungsträgern von mehr als 10¹⁸ cm⁻³ auf. Insbesondere kann die Konzentration an freien Ladungsträgern zwischen 10¹⁸ cm⁻³ und 10²¹ cm⁻³ betragen.

Außerhalb der Oberflächendotierzone weist das Trägersubstrat vorzugsweise eine Konzentration an freien Ladungsträgern von weniger als 10¹⁶ cm⁻³ auf. Insbesondere wird als Trägersubstrat ein undotiertes Halbleitersubstrat, insbesondere ein undotiertes Siliziumsubstrat oder Germaniumsubstrat verwendet.

Der spezifische Widerstand des Trägersubstrats beträgt vorzugsweise außerhalb der Oberflächendotierzone mehr als 200 Ωcm.

Durch die geringe Ladungsträgerkonzentration und den dadurch bedingten vergleichsweise großen spezifischen Widerstand des Trägersubstrats außerhalb der Oberflächendotierzone wirkt das Trägersubstrat außerhalb der Oberflächendotierzone als elektrischer Isolator. Dies hat den Vorteil, dass das Trägersubstrat Seitenflanken aufweisen kann, die unbeschichtet sind. Insbesondere müssen die Seitenflanken des Trägersubstrats nicht mit einer elektrisch isolierenden Schicht passiviert werden. Dies wäre bei einem Trägersubstrat aus einem elektrisch leitenden Material erforderlich, da ansonsten die Gefahr eines elektrischen Kurzschlusses an den Seitenflanken des Trägersubstrats bestehen würde. Die Gefahr eines Kurzschlusses besteht insbesondere dann, wenn die Durchkontaktierungen an der zweiten Hauptfläche des Trägersubstrats mittels einer Lötverbindung, beispielsweise mit den Leiterbahnen einer Leiterplatte, verbunden werden. In diesem Fall wäre es möglich, dass das Lot beim Lötprozess bis an die Seitenflanken des Trägersubstrats aufsteigt, so dass es im Fall eines Trägersubstrats aus einem elektrisch leitenden Material zu einem Kurzschluss kommen könnte. Diese Gefahr wird dadurch, dass das Trägersubstrat außerhalb der Oberflächendotierzone vorteilhaft undotiert ist und somit einen geringen spezifischen Widerstand von vorzugsweise mehr als 200 Ωcm und eine geringe Ladungsträgerkonzentration von vorzugsweise weniger als 10¹⁶ cm⁻³ aufweist, vorteilhaft vermindert. Ein Leckstrom beim Anlegen einer Spannung von 4V an die durch die Durchkontaktierungen ausgebildeten rückseitigen Kontakte des Trägersubstrats beträgt vorzugsweise weniger als 1 µA.

Bei einer weiteren vorteilhaften Ausgestaltung enthält der p-leitende Bereich einen p⁺-leitenden Bereich, wobei unter dem "p⁺-leitenden Bereich" ein p-leitender Bereich verstanden wird, der eine höhere Konzentration des p-Dotierstoffs als der übrige p-leitende Bereich aufweist. Vorzugsweise beträgt die Dotierstoffkonzentration in dem p⁺-leitenden Bereich mindestens 1*10²⁰ cm⁻³.

Der zweite Teilbereich der Lotschicht ist bei dieser Ausgestaltung in dem p⁺-leitenden Bereich an den p-leitenden Bereich angeschlossen. Beispielsweise kann der zweite Teilbereich der Lotschicht mittels einer Kontaktmetallisierung an den p⁺-leitenden Bereich angeschlossen sein, wobei der übrige p-leitende Bereich durch eine elektrisch isolierende Schicht von der Lotschicht getrennt ist. Durch die hohe Dotierstoffkonzentration in dem p⁺-leitenden Bereich wird vorteilhaft ein geringer Kontaktwiderstand an der Grenzfläche zwischen dem Halbleitermaterial und der Kontaktmetallisierung erzielt.

Der erste Teilbereich der Lotschicht ist vorzugsweise mittels einer weiteren Kontaktmetallisierung an den n-leitenden Bereich angeschlossen und mittels einer elektrisch isolierenden Schicht von der übrigen Oberflächendotierzone elektrisch isoliert.

Der p⁺-leitende Bereich ist vorzugsweise, in einer Aufsucht auf die erste Hauptfläche des Trägersubstrats gesehen, ringförmig um die erste Durchkontaktierung herum angeordnet, und zwar vorzugsweise derart, dass der ringförmige p⁺-leitende Bereich einen größeren Radius aufweist als der ringförmige n-leitende Bereich. Der ringförmige p⁺-leitende Bereich ist also außerhalb des ringförmigen n-leitenden Bereichs angeordnet.

Zwischen dem ringförmigen n-leitenden Bereich und dem ringförmigen p⁺-leitenden Bereich kann ein Teil des übrigen p-leitenden Bereichs angeordnet sein. Der pn-Übergang, der die Schutzdiode ausbildet, ist somit an der Außenfläche des ringförmigen n-leitenden Bereichs angeordnet. Die ringförmige Ausbildung des n-leitenden Bereichs hat den Vorteil, dass mit geringem Herstellungsaufwand ein pn-Übergang mit vergleichsweise großer Fläche hergestellt werden kann. Die so hergestellte Schutzdiode hat daher eine hohe Stromtragfähigkeit.

Die Erfindung wird im Folgenden anhand eines Ausführungsbeispiels im Zusammenhang mit den Figuren 1 bis 3 näher erläutert.

Es zeigen:
Figur 1 eine schematische Darstellung eines Querschnitts durch ein optoelektronisches Bauelement gemäß einem Ausführungsbeispiel,
Figur 2 eine schematische Darstellung einer Aufsicht auf einen Teilbereich der ersten Hauptfläche des Trägersubstrats im Bereich der ersten Durchkontaktierung bei dem Ausführungsbeispiel, und
Figur 3 eine schematische Darstellung eines Querschnitts durch den in Figur 2 in einer Aufsicht dargestellten Teilbereich des Trägersubstrats.

Die in den Figuren dargestellten Bestandteile sowie die Größenverhältnisse der Bestandteile untereinander sind nicht als maßstabsgerecht anzusehen.

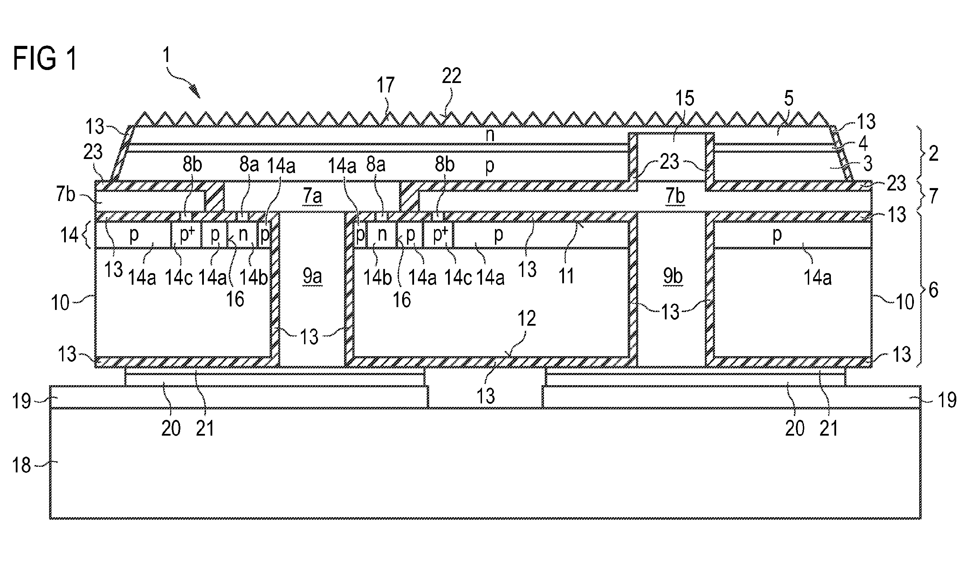

Bei dem in Figur 1 dargestellten Ausführungsbeispiel eines optoelektronischen Bauelements gemäß der Erfindung handelt es sich um eine LED. Die LED weist einen Halbleiterkörper 1 auf, der eine Epitaxieschichtenfolge 2 mit einer zur Strahlungsemission geeigneten aktiven Schicht 4 aufweist. Die Epitaxieschichtenfolge kann zum Beispiel auf einem Nitridverbindungshalbleitermaterial basieren. "Auf einem Nitridverbindungshalbleiter basierend" bedeutet im vorliegenden Zusammenhang, dass die Halbleiterschichtenfolge oder zumindest eine Schicht davon ein III-Nitrid-Verbindungshalbleitermaterial, vorzugsweise InₓAl_{y}Ga_{1-x-y}N umfasst, wobei 0 ≤ x ≤ 1, 0 ≤ y≤ 1 und x + y ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des InₓAl_{y}Ga_{1-x-y}N-Materials im Wesentlichen nicht ändern. Der Einfachheit halber beinhaltet obige Formel jedoch nur die wesentlichen Bestandteile des Kristallgitters (In, Al, Ga, N), auch wenn diese teilweise durch geringe Mengen weiterer Stoffe ersetzt sein können.

Die aktive Schicht 4 kann beispielsweise einen pn-Übergang oder eine Einfach- oder Mehrfachquantentopfstruktur zur Strahlungserzeugung aufweisen. Die aktive Schicht 4 ist zwischen einem p-dotierten Halbleiterbereich 3 und einem n-dotierten Halbleiterbereich 5 angeordnet. Die Seitenflanken des Halbleiterkörpers 1 sind vorteilhaft mit einer isolierenden Schicht 13 versehen.

Der Halbleiterkörper 1 kann an seiner Strahlungsaustrittsfläche 22 aufgeraut oder mit einer Strukturierung 17 versehen sein, um die Strahlungsauskopplung aus dem Halbleiterkörper 1 zu verbessern. Die Strukturierung oder Aufrauung des Halbleiterkörpers 1 an der Strahlungsaustrittsfläche 22 kann insbesondere mit einem Ätzprozess erfolgen.

Bei der LED gemäß dem Ausführungsbeispiel handelt es sich um eine so genannte Dünnfilm-LED, von der ein zum Aufwachsen der Epitaxieschichtenfolge 2 verwendetes Aufwachssubstrat nachträglich von der Epitaxieschichtenfolge 2 abgelöst wurde. Das ursprüngliche Aufwachssubstrat wurde von der Seite des Halbleiterkörpers 1 abgelöst, an der sich nun die Strahlungsaustrittsfläche 22 befindet.

An einer der Strahlungsaustrittsfläche 22 gegenüberliegenden Oberfläche ist der Halbleiterkörper 1 mittels einer Lotschicht 7 mit einem Trägersubstrat 6 verbunden. Die Verbindung des Halbleiterkörpers 1 mit dem Trägersubstrat 6 erfolgt bei der Herstellung des Bauelements vorzugsweise, bevor das ursprüngliche Aufwachssubstrat von der nun als Strahlungsaustrittsfläche 22 dienenden Oberfläche des Halbleiterkörpers 1 abgelöst wird. Da das Trägersubstrat 6 im Gegensatz zum Aufwachssubstrat nicht zum epitaktischen Aufwachsen der Epitaxieschichtenfolge 2 geeignet sein muss, besteht für das Trägersubstrat 6 eine vergleichsweise große Freiheit bei der Materialauswahl. Insbesondere kann ein Trägersubstrat 6 ausgewählt werden, das sich durch vergleichsweise geringe Kosten und/oder eine gute Wärmeleitfähigkeit auszeichnet.

Die Lotschicht 7 ist vorzugsweise aus einem Metall oder einer Metalllegierung gebildet, die insbesondere Au, Sn oder AuSn enthalten kann.

Das Trägersubstrat 6 weist eine dem Halbleiterkörper 1 zugewandte erste Hauptfläche 11 und eine vom Halbleiterkörper abgewandte zweite Hauptfläche 12 auf. Das Trägersubstrat 6 weist eine erste Durchkontaktierung 9a und eine zweite Durchkontaktierung 9b auf, die jeweils von der ersten Hauptfläche 11 zur zweiten Hauptfläche 12 des Trägersubstrats 6 geführt sind. Die Durchkontaktierungen 9a, 9b können beispielsweise Ag, Au oder CuW enthalten.

Das Trägersubstrat 6 ist aus einem Halbleitermaterial gebildet. Insbesondere kann das Trägersubstrat 6 ein Siliziumsubstrat oder ein Germaniumsubstrat sein. Die Verwendung eines Trägersubstrats 6 aus einem Halbleitermaterial wie beispielsweise Silizium hat den Vorteil, dass das Trägersubstrat 6 vergleichsweise kostengünstig ist und vergleichsweise einfach mit standardisierten Halbleiterprozessen bearbeitet werden kann.

Zur Vermeidung von Kurzschlüssen in dem optoelektronischen Bauelement sind die erste Hauptfläche 11 und die zweite Hauptfläche 12 des Trägersubstrats 6, abgesehen von den Durchkontaktierungen 9a, 9b, mit einer elektrisch isolierenden Schicht 13 versehen. Um das Halbleitermaterial des Trägersubstrats 6 von den Durchkontaktierungen 9a, 9b zu isolieren, sind auch die Innenwände der Durchkontaktierungen 9a, 9b jeweils mit der elektrisch isolierenden Schicht 13 versehen.

Die Herstellung der elektrisch leitenden Durchkontaktierungen 9a, 9b in dem Trägersubstrat 6 kann beispielsweise derart erfolgen, dass ein flüssiges Metall oder eine flüssige Metalllegierung in Durchbrüche des Trägersubstrats 6 hineingepresst wird (liquid solder fill).

Die beiden Durchkontaktierungen 9a, 9b dienen zur elektrischen Kontaktierung des Halbleiterkörpers 1. Beispielsweise ist die erste Durchkontaktierung 9a mit dem p-dotierten Halbleiterbereich 3 der Epitaxieschichtenfolge 2 und die zweite Durchkontaktierung 9b mit dem n-dotierten Halbleiterbereich 5 elektrisch leitend verbunden.

Eine elektrisch leitende Verbindung zwischen der ersten Durchkontaktierung 9a und dem p-dotierten Bereich 3 der Epitaxieschichtenfolge 2 kann durch die Lotschicht 7 erfolgen, die zwischen dem Halbleiterkörper 1 und dem Trägersubstrat 6 angeordnet ist. Insbesondere grenzt die erste Durchkontaktierung 9a an einen ersten Teilbereich 7a der Lotschicht 7 an, der elektrisch mit dem p-dotierten Halbleiterbereich 3 verbunden ist. Der p-dotierte Halbleiterbereich 3 muss nicht notwendigerweise direkt an die Lotschicht 7 angrenzen, wie es in Figur 1 dargestellt ist. Vielmehr können zwischen dem p-dotierten Halbleiterbereich 3 und der Lotschicht 7 weitere Schichten angeordnet sein, insbesondere eine Spiegelschicht (nicht dargestellt), die von der aktiven Schicht 4 in Richtung des Trägersubstrats emittierte Strahlung zur Strahlungsaustrittsfläche 22 umlenkt. Zusätzlich zur Spiegelschicht können auch noch weitere Schichten zwischen dem p-dotierten Halbleiterbereich 3 und der Lotschicht 7 angeordnet sein, beispielsweise Barriere-, Benetzungs- oder Haftvermittlerschichten, die beispielsweise eine Diffusion des Lotmaterials der Lotschicht 7 in die Spiegelschicht verhindern oder die Benetzung des Halbleiterkörpers 1 mit dem Lotmaterial verbessern.

Die zweite Durchkontaktierung 9b ist vorteilhaft mit dem n-dotierten Halbleiterbereich 5 elektrisch leitend verbunden. Dies kann beispielsweise derart erfolgen, dass ein zweiter Teilbereich 7b der Lotschicht 7 durch Isolierschichten 23 von der übrigen Lotschicht 7 und vom p-dotierten Halbleiterbereich 3 isoliert ist. Von dem Teilbereich 7b der Lotschicht 7 ist ein Durchgangskontakt 15 durch einen Durchbruch durch die Epitaxieschichtenfolge 2 bis in den n-dotierten Halbleiterbereich 5 geführt. Der Durchgangskontakt 15 ist durch eine isolierende Schicht 23 von dem p-dotierten Halbleiterbereich 3 und der aktiven Schicht 4 isoliert.

Die Kontaktierung des optoelektronischen Bauelements mittels eines durch die aktive Zone 4 geführten Durchgangskontakts 15 hat den Vorteil, dass sowohl die Kontaktierung des n-dotierten Halbleiterbereichs 5 als auch des p-dotierten Halbleiterbereichs 3 von der dem Trägersubstrat 6 zugewandten Seite des Halbleiterkörpers 1 aus erfolgt. Die Strahlungsaustrittsfläche 22 des optoelektronischen Bauelements ist daher vorteilhaft frei von elektrischen Kontaktelementen wie beispielsweise Bondpads, Kontaktmetallisierungen oder Anschlussdrähten. Auf diese Weise wird eine Absorption von Strahlung durch Kontaktelemente an der Strahlungsaustrittsfläche 22 verhindert.

An der dem Halbleiterkörper 1 gegenüberliegenden zweiten Hauptfläche 12 des Trägersubstrats 6 können die Durchkontaktierungen 9a, 9b vorteilhaft von außen angeschlossen werden. Insbesondere können die elektrisch leitenden Durchkontaktierungen 9a, 9b an der zweiten Hauptfläche des Trägersubstrats 6 beispielsweise mit den Leiterbahnen 19 einer Leiterplatte 18 verbunden werden. Die Durchkontaktierungen 9a, 9b können beispielsweise an der zweiten Hauptfläche 12 des Trägersubstrats 6 jeweils mit einer Metallisierungsschicht 21, beispielsweise einer NickelSchicht, versehen sein, die jeweils mit einer Lotschicht 20 mit den Leiterbahnen 19 der Leiterplatte 18 verbunden wird. Das optoelektronische Bauelement ist also vorteilhaft oberflächenmontierbar.

An der ersten Hauptfläche 11 des Trägersubstrats 6 ist eine Oberflächendotierzone 14 ausgebildet. Die Oberflächendotierzone 14 erstreckt sich mit Ausnahme der Durchkontaktierungen 9a, 9b entlang der gesamten ersten Hauptfläche 11 des Trägersubstrats 6. Die Oberflächendotierzone 14 weist einen p-leitenden Bereich 14a auf, der einen p-Dotierstoff enthält. An den p-leitenden Bereich 14a grenzt ein n-leitender Bereich 14b an, so dass zwischen dem p-leitenden Bereich 14a und dem n-leitenden Bereich 14b ein pn-Übergang 16 ausgebildet ist.

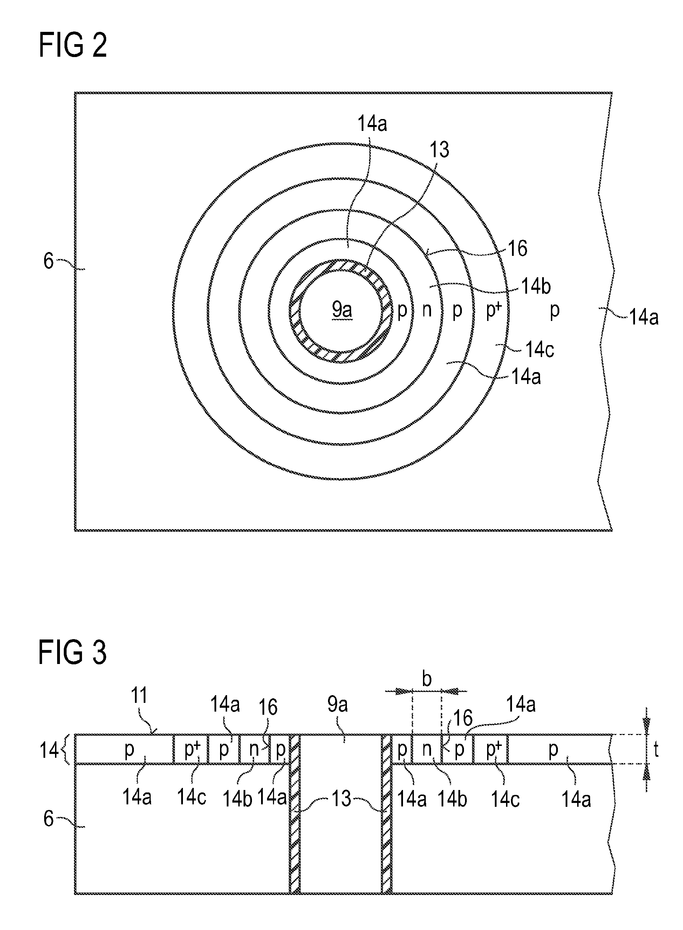

Wie in der Aufsicht in Figur 2 zu erkennen ist, ist der n-leitende Bereich 14b ringförmig um die erste Durchkontaktierung 9a herum angeordnet. Die ringförmige Ausbildung des n-leitenden Bereichs 14b in der Oberflächendotierzone 14 hat den Vorteil, dass der pn-Übergang 16 eine vergleichsweise große Fläche und daher eine große Stromtragfähigkeit in Sperrrichtung des optoelektronischen Bauelements aufweist.

Der p-leitende Bereich 14a der Oberflächendotierzone 14 enthält vorzugsweise einen Teilbereich 14c, der eine höhere Konzentration des p-Dotierstoffs als der übrige p-leitende Bereich 14a aufweist. Dieser Teilbereich 14c wird im Folgenden als p⁺-leitender Bereich 14c bezeichnet. Der p⁺-leitende Bereich 14c kann wie der n-leitende Bereich 14b ringförmig um die erste Durchkontaktierung 9a herum angeordnet sein. Vorzugsweise ist der ringförmige p⁺-leitende Bereich 14c außerhalb des ringförmigen n-leitenden Bereichs 14b angeordnet.

Wie in Figur 1 dargestellt, ist der n-leitende Bereich 14b mittels einer Kontaktmetallisierung 8a an den ersten Teilbereich der Lotschicht 7a angeschlossen. Auf diese Weise ist der n-leitende Bereich 14b elektrisch leitend mit dem p-dotierten Halbleiterbereich 3 der Epitaxieschichtenfolge 2 verbunden. Der p⁺-leitende Bereich 14c ist mittels einer weiteren Kontaktmetallisierung 8b an den zweiten Teilbereich 7b der Lotschicht 7 angeschlossen. Auf diese Weise ist der p⁺-leitende Bereich 14c elektrisch leitend mit dem n-dotierten Halbleiterbereich 5 der Epitaxieschichtenfolge 2 verbunden. In den Bereichen der Kontaktmetallisierungen 8a, 8b ist die elektrisch isolierende Schicht 13, die das Trägersubstrat 6 außerhalb der Durchkontaktierungen 9a, 9b von der Lotschicht 7 isoliert, unterbrochen.

Dadurch, dass der p⁺-leitende Bereich 14c über den zweiten Teilbereich 7b der Lotschicht und den Durchgangskontakt 15 mit dem n-dotierten Bereich 5 der Epitaxieschichtenfolge 2 und der n-leitende Bereich 14b über den ersten Teilbereich 7a der Lotschicht mit dem p-dotierten Halbleiterbereich 3 der Epitaxieschichtenfolge 2 verbunden ist, ist der pn-Übergang 16 der Dotierzone 14 antiparallel zur aktiven Schicht 4 des optoelektronischen Bauelements geschaltet. Der durch die Dotierzone 14 in dem Trägersubstrat 6 ausgebildete pn-Übergang 16 ist daher in Vorwärtsrichtung gepolt, wenn an den Durchkontaktierungen 9a, 9b eine Spannung anliegt, die in Sperrrichtung der aktiven Schicht 4 des optoelektronischen Bauelements gepolt ist. Die Dotierzone 14 bildet somit vorteilhaft eine ESD-Schutzdiode für das optoelektronische Bauelement aus.

Die Oberflächendotierzone 14 ist insbesondere dadurch herstellbar, dass in einem ersten Schritt ein p-Dotierstoff ganzflächig durch die erste Hauptfläche 11 in das Trägersubstrat 6 implantiert oder diffundiert wird. Die Oberflächendotierzone 14 weist vorteilhaft eine Tiefe t zwischen einschließlich 0,5 µm und einschließlich 4 µm auf. Die Dicke des Trägersubstrats 6 beträgt vorzugsweise zwischen einschließlich 100 µm und einschließlich 150 µm. Die Oberflächendotierzone ist also vorteilhaft nur in einem vergleichsweise kleinen oberflächennahen Bereich des Trägersubstrats 6 ausgebildet.

Außerhalb der Oberflächendotierzone 14 weist das Trägersubstrat 6 vorteilhaft eine Konzentration an freien Ladungsträgern von weniger als 10¹⁶ cm⁻³ auf. Der spezifische Widerstand beträgt außerhalb der Oberflächendotierzone vorzugsweise mehr als 200 Ωcm. Das Trägersubstrat 6 ist daher außerhalb der Oberflächendotierzone 14 ein guter elektrischer Isolator. Dies hat den Vorteil, dass die Seitenflanken 10 des Trägersubstrats 6 nicht mit einer elektrisch isolierenden Passivierungsschicht versehen werden müssen, um Kurzschlüsse an den Seitenflanken 10 zu vermeiden. Derartige Kurzschlüsse könnten beispielsweise auftreten, wenn sich das Material der Lotschicht 20, die das Trägersubstrat 6 mit der Leiterplatte 18 verbindet, an die Seitenflanken eines elektrisch leitfähigen Trägersubstrats 6 geraten würde. Aufgrund der elektrisch isolierenden Eigenschaften des Trägersubstrats 6 können die Seitenflanken 10 vorteilhaft unbeschichtet bleiben.

In der Oberflächendotierzone 14 beträgt die Konzentration an freien Ladungsträgern vorzugsweise mindestens 10¹⁸ cm⁻³, insbesondere zwischen 10¹⁸ cm⁻³ und 10²¹ cm⁻³.

Der n-leitende Bereich 14b wird vorteilhaft dadurch hergestellt, dass ein n-Dotierstoff in einen Teilbereich des zuvor ganzflächig p-dotierte Trägersubstrats 6 implantiert oder diffundiert wird. Das Implantieren oder Eindiffundieren des n-Dotierstoffs kann beispielsweise mit einer Maske erfolgen, die eine ringförmige Öffnung aufweist, so dass ein ringförmiger n-leitender Bereich 14b erzeugt wird, wie es in Figur 2 dargestellt ist. Die Konzentration des n-Dotierstoffs in dem n-leitenden Bereich 14b wird derart gewählt, dass sie höher ist als die Konzentration des zuvor implantierten oder diffundierten p-Dotierstoffs. Der n-leitende Bereich 14b weist also sowohl einen p-Dotierstoff als auch einen n-Dotierstoff auf, wobei die Konzentration des n-Dotierstoffs größer als die des p-Dotierstoffs ist, so dass das Halbleitermaterial in dem n-leitenden Bereich 14b insgesamt n-leitend ist.

Der p⁺-leitende Bereich 14c kann in dem p-leitenden Bereich 14a wie der n-leitende Bereich 14b mittels einer Maske erzeugt werden, die eine ringförmige Öffnung aufweist. Durch die ringförmige Öffnung wird in den p⁺-leitenden Bereich 14c weiterer p-Dotierstoff implantiert, so dass der p⁺-leitende Bereich eine höhere Konzentration des p-Dotierstoffs als der übrige p-leitende Bereich 14a aufweist.

Der n-leitende Bereich 14b und/oder der p⁺-leitende Bereich 14c weisen vorzugsweise jeweils eine Breite b zwischen einschließlich 5 µm und einschließlich 20 µm auf. Zwischen dem n-leitenden Bereich 14b und dem p⁺-leitenden Bereich 14c kann ein ebenfalls ringförmiger Teilbereich des p-leitenden Bereichs 14a angeordnet sein, der vorzugsweise ebenfalls eine Breite zwischen einschließlich 5 µm und einschließlich 20 µm aufweist.

Die Erfindung ist nicht durch die Beschreibung anhand der Ausführungsbeispiele beschränkt.

## Patentansprüche

1. Optoelektronisches Bauelement mit einem Halbleiterkörper (1), der eine Epitaxieschichtenfolge (2) mit einer zur Strahlungserzeugung geeigneten aktiven Schicht (4) aufweist, und einem Trägersubstrat (6) aus einem Halbleitermaterial, das mittels einer Lotschicht (7) mit dem Halbleiterkörper (1) verbunden ist,
wobei
- das Trägersubstrat (6) eine erste Durchkontaktierung (9a) und eine zweite Durchkontaktierung (9b) aufweist, die jeweils von einer dem Halbleiterkörper (1) zugewandten ersten Hauptfläche (11) des Trägersubstrats (6) zu einer vom Halbleiterkörper (1) abgewandten zweiten Hauptfläche (12) des Trägersubstrats (6) geführt sind,
- die Epitaxieschichtenfolge (2) einen p-dotierten Halbleiterbereich (3) und einen n-dotierten Halbleiterbereich (5) aufweist, wobei die erste Durchkontaktierung (9a) über einen ersten Teilbereich (7a) der Lotschicht (7) mit dem p-dotierten Halbleiterbereich (3) und die zweite Durchkontaktierung(9b) über einen zweiten Teilbereich (7b) der Lotschicht mit dem n-dotierten Halbleiterbereich (5) elektrisch leitend verbunden sind, **dadurch gekennzeichnet, dass**
- das Trägersubstrat (6) eine Oberflächendotierzone (14) aufweist, die sich entlang der ersten Hauptfläche (11) erstreckt,
- die Oberflächendotierzone (14) einen p-leitenden Bereich (14a) aufweist, der einen p-Dotierstoff enthält,
- die Oberflächendotierzone (14) einen an den p-leitenden Bereich (14a) angrenzenden n-leitenden Bereich (14b) aufweist, der sowohl einen n-Dotierstoff als auch einen p-Dotierstoff enthält, so dass zwischen dem p-leitenden Bereich (14a) und dem n-leitenden Bereich (14b) ein pn-Übergang (16) ausgebildet ist,
- der n-leitende Bereich (14b) an den ersten Teilbereich (7a) der Lotschicht (7) und der p-leitende Bereich (14a) an den zweiten Teilbereich der (7b) der Lotschicht (7) elektrisch angeschlossen sind, so dass der pn-Übergang (16) in der Oberflächendotierzone (14) eine Schutzdiode für den Halbleiterkörper (1) ausbildet, wobei der n-leitende Bereich (14b) ringförmig um die erste Durchkontaktierung (9a) herum angeordnet ist.

2. Optoelektronisches Bauelement nach Anspruch 1, wobei sich die Oberflächendotierzone (14) mit Ausnahme der Durchkontaktierungen (9a, 9b) entlang der gesamten ersten Hauptfläche (11) des Trägersubstrats (6) erstreckt.

3. Optoelektronisches Bauelement nach einem der vorhergehenden Ansprüche,
wobei der n-leitende Bereich (14b) eine Breite von 5 µm bis 20 µm aufweist.

4. Optoelektronisches Bauelement nach einem der vorhergehenden Ansprüche,
wobei das Trägersubstrat (6) ein Siliziumsubstrat oder eine Germaniumsubstrat ist.

5. Optoelektronisches Bauelement nach einem der vorhergehenden Ansprüche,
wobei das Trägersubstrat (6) eine Dicke zwischen einschließlich 100 µm und einschließlich 150 µm aufweist.

6. Optoelektronisches Bauelement nach einem der vorhergehenden Ansprüche,
wobei die Oberflächendotierzone (14) eine Tiefe von 0,5 µm bis 4 µm aufweist.

7. Optoelektronisches Bauelement nach einem der vorhergehenden Ansprüche,
wobei die Oberflächendotierzone (14) eine Konzentration an freien Ladungsträgern von mehr als 10¹⁸ cm⁻³ aufweist.

8. Optoelektronisches Bauelement nach einem der vorhergehenden Ansprüche,
wobei das Trägersubstrat (6) außerhalb der Oberflächendotierzone (14) eine Konzentration an freien Ladungsträgern von weniger als 10¹⁶ cm⁻³ aufweist.

9. Optoelektronisches Bauelement nach einem der vorhergehenden Ansprüche,
wobei das Trägersubstrat (6) außerhalb der Oberflächendotierzone (14) einen spezifischen Widerstand von mehr als 200 Ωcm aufweist.

10. Optoelektronisches Bauelement nach einem der vorhergehenden Ansprüche,
wobei das Trägersubstrat (6) Seitenflanken (10) aufweist, die unbeschichtet sind.

11. Optoelektronisches Bauelement nach einem der vorhergehenden Ansprüche,
wobei der p-leitende Bereich (14a) einen p⁺-leitenden Bereich (14c) enthält, der eine höhere Konzentration des p-Dotierstoffs als der übrige p-leitende Bereich (14a) aufweist.

12. Optoelektronisches Bauelement nach Anspruch 11,
wobei der zweite Teilbereich (7b) der Lotschicht (7) in dem p⁺-leitenden Bereich (14c) an den p-leitenden Bereich (14a) angeschlossen ist.

13. Optoelektronisches Bauelement nach Anspruch 11 oder 12, wobei der p⁺-leitende Bereich (14c) ringförmig um die erste Durchkontaktierung (9a) herum angeordnet ist.

14. Optoelektronisches Bauelement nach Anspruch 13,
wobei zwischen dem ringförmigen n-leitenden Bereich (14b) und dem ringförmigen p⁺-leitenden Bereich (14c) ein Teil des p-leitenden Bereichs (14a) angeordnet ist.

## Claims

1. Optoelectronic component comprising a semiconductor body (1), which has an epitaxial layer sequence (2) comprising an active layer (4) suitable for generating radiation, and a carrier substrate (6) composed of a semiconductor material, which is connected to the semiconductor body (1) by means of a solder layer (7),
wherein
- the carrier substrate (6) has a first plated-through hole (9a) and a second plated-through hole (9b), which are led in each case from a first main surface (11) of the carrier substrate (6) facing the semiconductor body (1) to a second main surface (12) of the carrier substrate (6) facing away from the semiconductor body (1),
- the epitaxial layer sequence (2) has a p-doped semiconductor region (3) and an n-doped semiconductor region (5), wherein the first plated-through hole (9a) is electrically conductively connected to the p-doped semiconductor region (3) by means of a first partial region (7a) of the solder layer (7) and the second plated-through hole (9b) is electrically conductively connected to the n-doped semiconductor region (5) by means of a second partial region (7b) of the solder layer,
**characterized in that**
- the carrier substrate (6) has a surface doping zone (14) extending along the first main surface (11),
- the surface doping zone (14) has a p-conducting region (14a) containing a p-type dopant,
- the surface doping zone (14) has an n-conducting region adjoining the p-conducting region (14a) and containing both an n-type dopant and a p-type dopant, such that a pn junction (16) is formed between the p-conducting region (14a) and the n-conducting region (14b),
- the n-conducting region (14b) is electrically connected to the first partial region (7a) of the solder layer (7) and the p-conducting region (14a) is electrically connected to the second partial region (7b) of the solder layer (7), such that the pn junction (16) in the surface doping zone (14) forms a protective diode for the semiconductor body (1), wherein the n-conducting region (14b) is arranged in a ring-shaped manner around the first plated-through hole (9a).

2. Optoelectronic component according to claim 1, wherein the surface doping zone (14) with the exception of the plated-through holes (9a, 9b) extends along the entire first main surface (11) of the carrier substrate (6).

3. Optoelectronic component according to either of the preceding claims,
wherein the n-conducting region (14b) has a width of 5 µm to 20 µm.

4. Optoelectronic component according to any one of the preceding claims,
wherein the carrier substrate (6) is a silicon substrate or a germanium substrate.

5. Optoelectronic component according to any one of the preceding claims,
wherein the carrier substrate (6) has a thickness of between 100 µm and 150 µm inclusive.

6. Optoelectronic component according to any one of the preceding claims,
wherein the surface doping zone (14) has a depth of 0.5 µm to 4 µm.

7. Optoelectronic component according to any one of the preceding claims,
wherein the surface doping zone (14) has a concentration of free charge carriers of more than 1018 cm⁻³.

8. Optoelectronic component according to any one of the preceding claims,
wherein the carrier substrate (6) outside the surface doping zone (14) has a concentration of free charge carriers of less than 10¹⁶ cm⁻³.

9. Optoelectronic component according to any one of the preceding claims,
wherein the carrier substrate (6) outside the surface doping zone (14) has a specific resistivity of more than 200 Ωcm.

10. Optoelectronic component according to any one of the preceding claims,
wherein the carrier substrate (6) has sidewalls (10) that are uncoated.

11. Optoelectronic component according to any one of the preceding claims,
wherein the p-conducting region (14a) contains a p⁺-conducting region (14c) having a higher concentration of the p-type dopant than the rest of the p-conducting region (14a).

12. Optoelectronic component according to claim 11, wherein the second partial region (7b) of the solder layer (7) in the p⁺-conducting region (14c) is connected to the p-conducting region (14a).

13. Optoelectronic component according to claim 11 or 12,
wherein the p⁺-conducting region (14c) is arranged in a ring-shaped manner around the first plated-through hole (9a).

14. Optoelectronic component according to claim 13,
wherein a part of the p-conducting region (14a) is arranged between the ring-shaped n-conducting region (14b) and the ring-shaped p⁺-conducting region (14c).

## Revendications

1. Composant optoélectronique comprenant un corps semiconducteur (1) qui possède une séquence de couches épitaxiales (2) comprenant une couche (4) active adaptée pour générer un rayonnement, et un substrat porteur (6) en un matériau semiconducteur, lequel est relié au corps semiconducteur (1) au moyen d'une couche de brasure (7),
- le substrat porteur (6) possédant un premier contact traversant (9a) et un deuxième contact traversant (9b) qui s'étendent respectivement d'une première surface principale (11) du substrat porteur (6) faisant face au corps semiconducteur (1) à une deuxième surface principale (12) du substrat porteur (6) à l'opposé du corps semiconducteur (1),
- la séquence de couches épitaxiales (2) possédant une zone semiconductrice dopée p (3) et une zone semiconductrice dopée n (5), le premier contact traversant (9a) étant relié de manière électriquement conductrice à la zone semiconductrice dopée p (3) par le biais d'une première zone partielle (7a) de la couche de brasure (7) et le deuxième contact traversant (9b) à la zone semiconductrice dopée n (5) par le biais d'une deuxième zone partielle (7b) de la couche de brasure,
**caractérisé en ce que**
- le substrat porteur (6) possède une zone dopée en surface (14) qui s'étend le long de la première surface principale (11),
- la zone dopée en surface (14) possède une zone conductrice p (14a) qui contient une substance de dopage p,
- la zone dopée en surface (14) possède une zone conductrice n (14b) juxtaposée à la zone conductrice p (14a), laquelle contient à la fois une substance de dopage n et une substance de dopage p, de sorte qu'une transition pn (16) est formée entre la zone conductrice p (14a) et la zone conductrice n (14b),
- la zone conductrice n (14b) est raccordée électriquement à la première zone partielle (7a) de la couche de brasure (7) et la zone conductrice p (14a) à la deuxième zone partielle (7b) de la couche de brasure (7), de sorte que la transition pn (16) forme dans la zone dopée en surface (14) une diode de protection pour le corps semiconducteur (1), la zone conductrice n (14b) étant disposée en forme d'anneau autour du premier contact traversant (9a).

2. Composant optoélectronique selon la revendication 1, la zone dopée en surface (14) s'étendant le long de toute la première surface principale (11) du substrat porteur (6), à l'exception des contacts traversants (9a, 9b).

3. Composant optoélectronique selon l'une des revendications précédentes, la zone conductrice n (14b) possédant une largeur de 5 µm à 20 µm.

4. Composant optoélectronique selon l'une des revendications précédentes, le substrat porteur (6) étant un substrat en silicium ou un substrat en germanium.

5. Composant optoélectronique selon l'une des revendications précédentes, le substrat porteur (6) possédant une épaisseur comprise entre 100 µm inclus et 150 µm inclus.

6. Composant optoélectronique selon l'une des revendications précédentes, la zone dopée en surface (14) possédant une profondeur de 0,5 µm à 4 µm.

7. Composant optoélectronique selon l'une des revendications précédentes, la zone dopée en surface (14) possédant une concentration de porteurs de charge libres supérieure à 10¹⁸/cm⁻³.

8. Composant optoélectronique selon l'une des revendications précédentes, le substrat porteur (6) possédant, en-dehors de la zone dopée en surface (14), une concentration de porteurs de charge libres inférieure à 10¹⁶/cm⁻³.

9. Composant optoélectronique selon l'une des revendications précédentes, le substrat porteur (6) possédant, en-dehors de la zone dopée en surface (14), une résistance spécifique supérieure à 200 Ωcm.

10. Composant optoélectronique selon l'une des revendications précédentes, le substrat porteur (6) possédant des flancs latéraux (10) qui sont exempts de revêtement.

11. Composant optoélectronique selon l'une des revendications précédentes, la zone conductrice p (14a) contenant une zone conductrice p⁺ (14c) qui possède une concentration de la substance de dopage p supérieure à celle du reste de la zone conductrice p (14a).

12. Composant optoélectronique selon la revendication 11, la deuxième zone partielle (7b) de la couche de brasure (7) étant raccordée à la zone conductrice p (14a) dans la zone conductrice p⁺ (14c).

13. Composant optoélectronique selon la revendication 11 ou 12, la zone conductrice p⁺ (14c) étant disposée en forme d'anneau autour du premier contact traversant (9a).

14. Composant optoélectronique selon la revendication 13, une partie de la zone conductrice p (14a) étant disposée entre la zone conductrice n (14b) de forme annulaire et la zone conductrice p⁺ (14c) de forme annulaire.
